# EUROPÄISCHE PATENTSCHRIFT

(11) **EP 0 990 167 B1**
(45) Veröffentlichungstag und Bekanntmachung des Hinweises auf die Patenterteilung: **07.06.2006**
(21) Anmeldenummer: 99903577.7
(22) Anmeldetag: 22.02.1999
(51) Int. Cl.: G01R 31/36

(54) **BATTERIEMESSKLEMME**
BATTERY MEASURING TERMINAL
PINCE DE MESURE POUR BATTERIE

(30) Priorität: 17.04.1998 CH 88298
(43) Veröffentlichungstag der Anmeldung: 05.04.2000
(73) Patentinhaber: AK Systemtechnik AG, 2950 Courgenay (CH)
(72) Erfinder: MELCHER, Domenic, CH-8610 Uster (CH)
(74) Vertreter: Salgo, Reinhold Caspar
(86) Internationale Anmeldenummer: PCT/CH1999/000085
(87) Internationale Veröffentlichungsnummer: WO 1999/054744

(56) Entgegenhaltungen:
- EP-A- 0 725 412
- WO-A-90/02432
- US-A- 4 675 255
- US-A- 5 700 089

## Beschreibung

Die vorliegende Erfindung betrifft elektrische Gleichspannungssysteme mit Batterien, welche zur Speicherung und Lieferung von elektrischer Energie in verschiedensten Anwendungen Verwendung finden, beispielsweise in Land-, Luft- oder Wasserfahrzeugen insbesondere als Hilfsenergiequellen zum Starten eines Hauptmotors, oder als Speicherelemente in USV-Anlagen, Solaranlagen oder Windgeneratoranlagen, nach dem Oberbegriff des Patentanspruchs 1.

Die Dokumente US-A-4 675 255 (D1) und EP-A-0 725 412 (D2) beschreiben Vorrichtungen zur Messung des fliessenden Stromes an einem Batteriepol. In D1 wird eine Vorrichtung zur erleichterten Anbringung eines Strommessgerätes, die zusätzlich zum Batteriekabel an der Klemme befestigt wird beschrieben. D2, das den nächstliegenden Stand der Technik bildet, beschreibt eine Sicherungsvorrichtung, die den fliessenden Strom am Batteriepol misst und bei zu hohen Werten die elektrische Verbindung trennt. Sensor, Auswerteschaltung und Trennvorrichtung befinden sich in einem Gehäuse nahe der Batterie. Beide bekannten Vorrichtungen sind dafür vorgesehen, den durchfliessenden Strom mittels eines Hall-Sensors zu messen. Die Anordnungen nach D1 und D2 liefern keine Informationen über den Ladungszustand der Batterie.

Die Erfindung wird im Folgenden am Beispiel von wiederaufladbaren Batterien weiter beschrieben, wozu insbesondere die in Automobilen gängigen Bleiakkumulatoren, aber auch die bekannten NiCd-Elemente gehören, ohne dass die Erfindung auf diese beiden Typen von Batterien eingeschränkt wäre.

Die Leistungsfähigkeit einer Batterie der genannten Art ist, bei einer gegebenen Nennkapazität, hauptsächlich von ihrem Ladezustand, von der Art und der Anzahl der vorausgegangenen Ladezyklen und stark von ihrer Betriebstemperatur abhängig. Bei Flurförderungsfahrzeugen, also beispielsweise bei Gabelstaplern, sowie bei Segelyachten ist die Nachladung der Batterie in möglichst kurzen Ladephasen und mit maximalem Ladestrom gefordert. Um die Lebensdauer der Batterie nicht zu verkleinern, darf dabei die sogenannte Gasspannung nicht überschritten werden. Die optimale Ladung kann nur unter Berücksichtigung der aktuellen Batterietemperatur durchgeführt werden. Wird die entladene Batterie beispielsweise in kaltem Zustand durch zu grosse Ströme in zu kurzer Zeit wiederaufgeladen, verkleinert sich neben ihrer Lebensdauer auch ihre Energiespeicherkapazität. Wird die Batterie nach einem längeren Unterbruch wieder in Betrieb genommen, ist in der Regel weder ihr Ladezustand noch ihre noch vorhandene Gesamtkapazität bekannt. Dies ist ein Nachteil, da in Unkenntnis dieser Daten eine allenfalls nicht mehr genügend leistungsfähige Batterie nicht oder zu spät ausgetauscht wird.

Sowohl bei der Ladung als auch der Entladung der Batterie sind neben der Temperatur auch die fliessenden Ströme, die vorhandene Klemmenspannung, die momentane elektrische Leis-tung sowie die insgesamt noch verfügbare Energie von Interesse: Bei der Entladung sind beispielsweise ein zu grosser Strom, eine unerwartet grosse Leistung, eine aussergewöhnlich tiefe Klemmenspannung oder eine erhöhte Temperatur Hinweise auf einen Kurzschluss. Bei der Ladung kann von einer erhöhten Temperatur auf eine schädliche Ueberladung geschlossen werden.

Die Bestimmung dieser als Beispiele angegebenen physikalischen Grössen, welche die Batterie betreffen, sowie deren Darstellung auf einer oder auf mehreren Anzeigeeinheiten stellen an und für sich keine prinzipiellen Probleme dar. Es ist dazu allerdings ein grosser Aufwand nötig, da für jede der interessierenden Grössen wie beispielsweise Temperatur, fliessender Strom oder Klemmenspannung ein eigener Sensor benötigt wird. Jeder dieser Sensoren muss dabei in der Regel über eine eigene Stromversorgung verfügen. In herkömmlichen, analogen Messsystemen benötigt jeder Sensorausgang eine eigene Uebertragungsleitung zur Anzeigeeinheit. Die Umwandlung der Sensorsignale in eine rechnerkonforme Form, beispielsweise in eine digitale Darstellung, die Verarbeitung dieser Daten in einem Rechner sowie die Uebermittlung der mit Hilfe des Rechners bestimmten physikalischen Grössen an eine oder an mehrere Anzeigeeinheiten ist mit weiterem Aufwand verbunden, muss doch auch dazu in der Regel zwischen Batterie und Anzeigeeinheit je eine mindestens zweiadrige Datenleitung von oft beträchtlicher Länge installiert werden.

Die Aufgabe, die mit der vorliegenden Erfindung gelöst wird, besteht darin, für elektrische Gleichspannungssysteme eine in einfachster Weise installierbare Vorrichtung zu schaffen, mit welcher eine Vielzahl von physikalischen Grössen, welche die Batterie betreffen, bestimmt und auf einer oder mehreren Anzeigeeinheiten zur Darstellung gebracht sowie zur Optimierung der Batterienutzung bei Ladung und Entladung verwendet werden.

Die Lösung dieser Aufgabe ist wiedergegeben in Patentanspruch 1 hinsichtlich der erfinderischen Gesamtidee und in den weiteren Patentansprüchen 2 bis 15 hinsichtlich vorteilhafter Ausführungsformen. Sie wird in den Figuren 1 bis 5 weiter erläutert.

Es zeigen
- Fig. 1: den Grundriss einer erfindungsgemässen Batteriemessklemme,
- Fig. 2: einen Einblick in das Innere einer Batteriemessklemme mit einem Spannungssensor,
- Fig. 3: einen Einblick in das Innere der Batteriemessklemme mit einem Stromsensor und einem Temperatursensor,
- Fig. 4: das Blockschaltbild eines Amperestunden-Zählers,
- Fig. 5: die schematische Darstellung einer Beschaltung der erfindungsgemässen Batteriemessklemme.

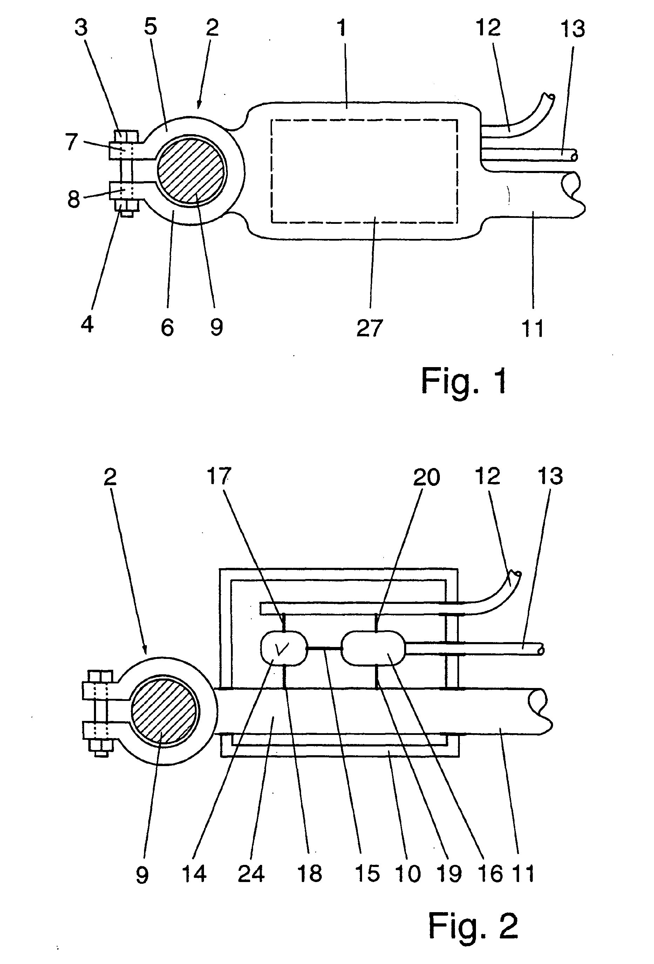

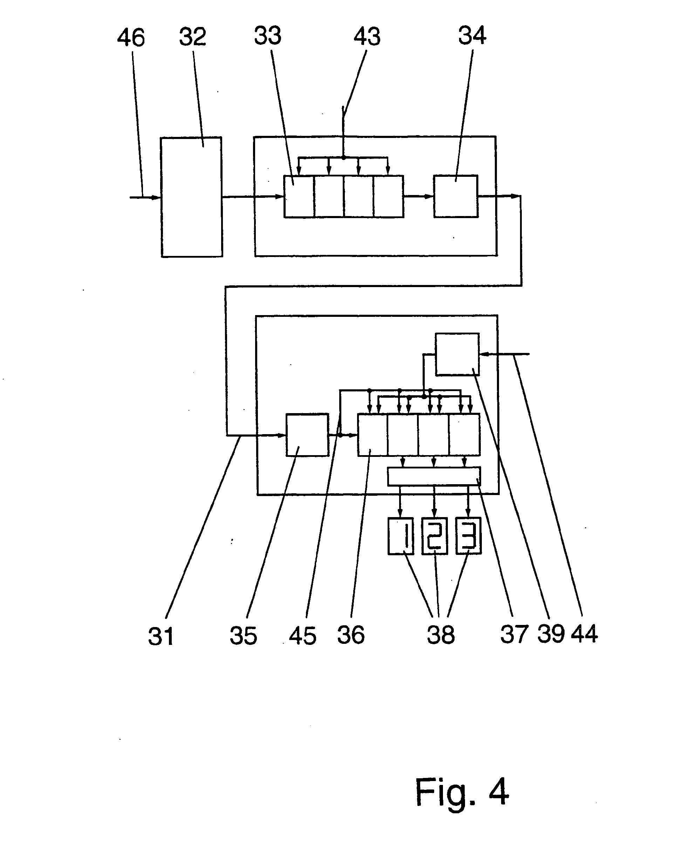

In Fig. 1 ist der Grundriss einer erfindungsgemässen Batteriemessklemme 1 dargestellt. Sie weist auf ihrer einen Seite eine bekannte Befestigungsmanschette 2 aus Metall auf, mit welcher die Batteriemessklemme 1 mit einem der beiden Anschluss-Pole einer Batterie, entweder mit dem positiven Anschluss-Pol 9 oder dem nicht eingezeichneten negativen Anschluss-Pol 47, fest verbunden werden kann. Die Befestigungsmanschette 2 enthält dazu beispielsweise zwei halbkreisförmige Bügel 5, 6 mit je einem Loch 7, 8. Die Befestigungsmanschette 2 wird über einen der Anschluss-Pole 9, 47 geschoben und mit einer durch die Löcher 7, 8 führenden Schraube 3 gegen eine Mutter 4 angezogen, wodurch sich eine sowohl elektrisch als auch thermisch gut leitende, feste Verbindung zwischen diesem Anschluss-Pol 9, 47 und der Batteriemessklemme 1 ergibt.

In der in dieser Fig. 1 gezeichneten ersten Variante geht die Befestigungsmanschette 2 über in eine Verdickung des gleichen, elektrisch leitenden Materialstücks, welche im Innern einen Hohlraum 27 enthält. Nach diesem Hohlraum 27 verjüngt sich die Befestigungsmanschette 2 wieder und geht dort in ein Batteriekabel 11 über, mit welchem sie in bekannter Weise fest und elektrisch leitend verbunden ist. In den Hohlraum 27 führt ein isoliertes Batteriekabel 12 hinein, welches mit dem anderen Anschluss-Pol, hier also mit dem negativen, der Batterie verbunden ist. Aus dem Hohlraum 27 führt eine isolierte Datenleitung 13 heraus.

In einer zweiten Variante ist die Befestigungsmanschette 2 mit einer Seite eines Gehäuses 10 fest verbunden und ragt teilweise in dieses hinein. Auf einer anderen Seite des Gehäuses 10 führen drei elektrische Leitungen weg, welche mit dem Gehäuse 10 fest verbunden sind, nämlich ein Batteriekabel 11, ein Batteriekabel 12, welches mit dem andern, hier also dem negativen, Anschluss-Pol der Batterie verbunden ist, sowie eine Datenleitung 13.

Der Einfachheit halber wird in der weiteren Beschreibung von dieser zweiten Variante ausgegangen, wobei aber die erste Variante immer mitgemeint ist.

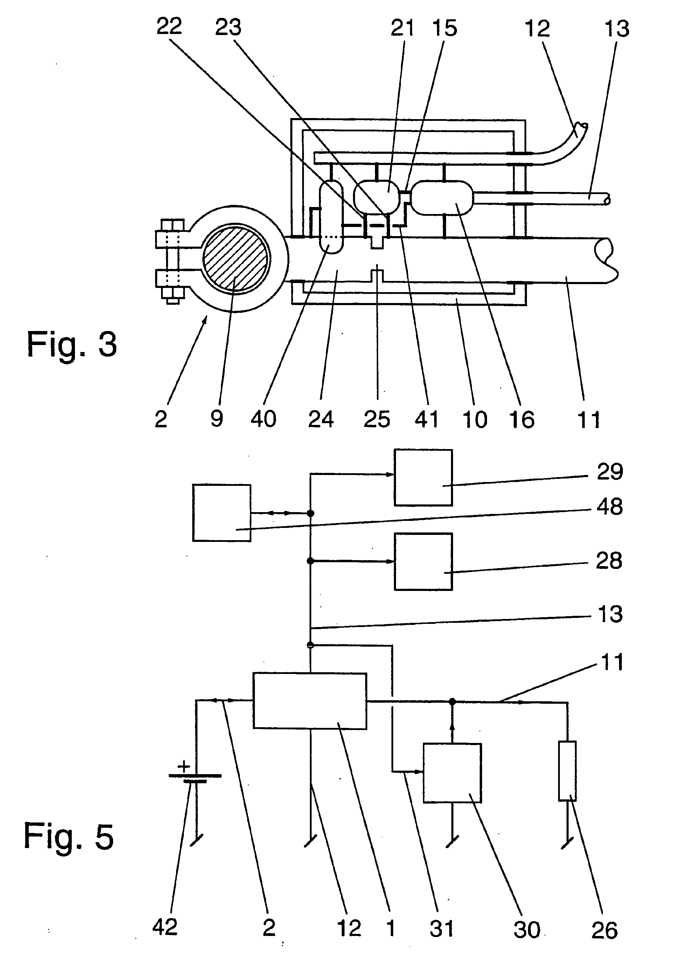

In den Fig. 2 und 3 ist der Hohlraum 27, respektive das Gehäuse 10, ohne Deckfläche dargestellt, so dass der Blick auf das Innere frei wird. Dieses ist im Betrieb abgeschlossen und damit vor agressiven Flüssigkeiten und Gasen geschützt. Ein verstärkter Schutz kann weiter dadurch realisiert werden, dass das Gehäuse 10 respektive der Hohlraum 27 zusammen mit den in ihm vorhandenen Bestandteilen mit einem isolierenden und aushärtenden Stoff, beispielsweise mit einem Kunstharz, ausgegossen ist. Das Innere enthält mindestens einen Sensor sowie Signalverarbeitungsmittel, worauf anhand der folgenden beiden Figuren weiter eingegangen wird.

Die Fig. 2 zeigt, im Innern der Batteriemessklemme 1, einen ersten Sensor 14 zur Messung der Batteriespannung. Er ist sowohl mit dem Batteriekabel 12 als auch mit einem in das Gehäuse 10 eintretenden Teil 24 der Befestigungsmanschette 2, welches sich auf dem elektrisch positiven Potential der Batterie befindet, über leitenden Verbindungen 17, 18 elektrisch verbunden. Dieser Sensor 14 misst die Klemmenspannung U der Batterie, wofür verschiedene Verfahren allgemein bekannt sind. Er ist über eine elektrische Verbindungsleitung 15 mit einer Signalverarbeitungseinheit 16 verbunden, welche ebenfalls im Innern des Gehäuses 10 vorhanden ist. Diese enthält einen elektrischen Ausgang, welcher mit der aus dem Gehäuse 10 herausführenden Datenleitung 13 verbunden ist. Die Versorgung der Signalverarbeitungseinheit 16 mit elektrischer Energie erfolgt ebenfalls direkt über weitere Verbindungen 19, 20 zu den beiden Batteriekabeln 11, 12.

Die Fig. 3 zeigt, im Innern der Batteriemessklemme 1, einen zweiten Sensor 21, mit welchem der aus der Batterie fliessende Strom I gemessen wird, sowie einen dritten Sensor 40, mit welchem die Temperatur der Batterie gemessen wird. Der zweite Sensor 21 ist mit dem in das Gehäuse 10 eintretenden Teil 24 der Befestigungsmanschette 2 über eine leitende Verbindung 22 verbunden. Der Teil 24 ist seinerseits über einen niederohmigen Shunt-Widerstand 25 mit elektrischem Widerstandwert R* mit dem Batteriekabel 11 verbunden, welches aus dem Gehäuse 10 wegführt. Ueber eine weitere elektrische Verbindung 23 ist der Sensor 21 auch mit dem wegführenden Batteriekabel 11 verbunden. Fliesst ein Strom I durch das Batteriekabel 11, baut sich über dem Shunt-Widerstand 25 eine dazu proportionale Spannung U* = R* I auf. Diese Spannung U* wird vom Sensor 21 gemessen und ergibt ein Signal, welches zu dem von der Batterie wegfliessenden elektrischen Strom I proportional ist. Dieses Signal wird mit den auch hier vorhandenen und bereits bei der Beschreibung von Fig. 2 erwähnten Mitteln ebenfalls einer Signalverarbeitungseinheit 16 zugeleitet, dort verarbeitet und in einer zur Uebergabe an eine Anzeigeeinheit geeigneten Form an die Datenleitung 13 übergeben.

Diese Art der Strommessung ist unvermeidbarerweise mit einem gewissen Verlust an Leistung verbunden. In drei Varianten wird bei der Bestimmung des Stroms I daher auf einen Shunt-Widerstand 25 verzichtet und stattdessen eine verlustlose Strommessung durchgeführt. Dazu wird das Magnetfeld gemessen, welches an einem gegebenen Ort in der Nähe des positiven Batteriekabels proportional zu dem darin fliessenden Strom ist. Sensoren für diese Art der Strommessung sind allgemein bekannt, beispielsweise aus dem Sonderheft Nr. 246 von "Elektronik" (Sensoren II, p. 69 f., Henri Hencke: Halleffekt- und Permalloy-Stromsensoren). In einer ersten Variante wird zur Strommessung ein Permalloy-Stromsensor eingesetzt. In einer zweiten Variante wird eine direkte Messung der Hall-Spannung in einem Hall-Sensor durchgeführt. In einer dritten Variante wird die im Sensor erzeugte Hall-Spannung auf Null kompensiert, wodurch eine erhöhte Genauigkeit der Strommessung erreicht wird. Entsprechende Sensoren für diese drei Varianten werden industriell gefertigt und und stehen dem Entwickler in verschiedenen Ausführungen, wahlweise mit Analog- oder Digital-Ausgang, zur Verfügung.

In dieser Ausführungsform enthält der innere Teil 24 der Befestigungsmanschette 2 den erwähnten Temperatursensor 40, welcher in innigem thermischen Kontakt mit der Befestigungsmanschette 2 steht. Da diese selber ebenfalls in gutem thermischen Kontakt mit dem Anschluss-Pol 9 der Batterie steht, weist sie im Wesentlichen auch die gleiche Temperatur wie die Batterie selber auf. Für die Messung der Temperatur sind verschiedene Methoden allgemein bekannt, beispielsweise PTC- oder NTC-Widerstände, PT-Messwiderstände, Thermoelemente, SI-Sensoren oder spezielle temperaturabhängig Schwingquarze mit stark temperaturabhängiger Frequenz. Ueber eine Verbindungsleitung 41 steht auch der Sensor 40 mit einem weiteren Eingang der Signalverarbeitungseinheit 16 in elektrischer Verbindung.

Die Stromversorgung des Stromsensors 21 und des Temperatursensors 40 geschieht in analoger Weise wie beim ersten Sensor 14 durch Verbindungen 17, 18 resp. 19, 20, welche hier aber, der Uebersichtlichkeit halber, nicht mehr speziell mit Nummern bezeichnet wurden.

Es ist ohne weiteres möglich, sinnvoll und ebenfalls erfindungsgemäss, eine beliebige Auswahl aus den vorgestellten Sensoren zu treffen und diese im Gehäuse 10 unterzubringen. Die Signalverarbeitungseinheit 16 weist dann eine entsprechende Anzahl von Eingängen und eine entsprechend grössere Kapazität auf. Ebenfalls erfindungsgemäss ist es, dass die Signalverarbeitungseinheit 16 einen analogen oder digitalen Multiplikator zur Berechnung des Produkts zweier Messwerte aufweist. Dadurch kann beispielsweise bereits in der Signalverarbeitungseinheit 16 die Momentan-Leistung P der Batterie als Produkt von Strom I und Klemmenspannung U berechnet, das Resultat auf die Datenleitung 13 gelegt werden und einer Anzeige zugeführt werden. Ebenfalls erfindungsgemäss ist es aber auch, die beiden Werte für Strom I und Klemmenspannung U zunächst weiterzuleiten, beispielsweise zu einer Anzeigetafel, und in der Nähe dieser Anzeigetafel auch die Hardware für die Multiplikation dieser beiden Werte zu plazieren.

In zwei weiteren Varianten der erfindungsgemässen Batteriemessklemme 1 enthält diese Mittel zur Bestimmung der Ladungsmenge in der Batterie. Die Vorrichtung arbeitet dabei als sogenannter Amperestunden-Zähler, und zwar sowohl bei der Ladung als auch, mit umgekehrtem Vorzeichen, bei der Entladung der Batterie.

In der ersten dieser Varianten ist im Gehäuse 10 zusätzlich zu einem Stromsensor ein Zeitmesser vorhanden. Entsprechende Elemente sind allgemein bekannt. Sie enthalten in der Regel einen Schwingquarz zur Generierung einer Zeiteinheit, welche durch elektronische Frequenzteilung in grössere Zeiteinheiten umgewandelt wird. Wegen des kleinen Volumens solcher Elemente ist es problemlos möglich, diese ebenfalls in das Gehäuse 10 der Batteriemessklemme 1 einzubauen. Ist in der Signalverarbeitungseinheit 16 allenfalls bereits ein Zeitmesser vorhanden, beispielsweise die Systemuhr eines Micro-Processors, kann direkt dieser Zeitmesser verwendet werden. Ein dem fliessenden Strom I proportionales Signal wird mit Hilfe des Zeitmessers numerisch über die Zeit integriert. Die Signalverarbeitungseinheit 16 kann dazu zusätzlich einen Micro-Prozessor enthalten, der den fliessenden Strom I numerisch über die Zeit integriert. Das Resultat, die in der Batterie noch vorhandene Ladung, wird dann in der bereits oben beschriebenen Weise der Datenleitung 13 übergeben.

Die Integration des Stroms über die Zeit kann natürlich auch mit Mitteln geschehen, welche sich ausserhalb des Gehäuses 10 befinden, worauf hier aber nicht weiter eingegangen werden soll.

Die zweite Variante zur Ermittlung der Ladungsmenge wird anhand von Fig. 4 weiter erläutert. Hier wird zunächst, mit einer der bekannten Messmethoden, eine dem fliessenden Strom I proportionale Spannung U* bestimmt. Diese Spannung U* wird dem Eingang 46 eines innerhalb des Gehäuses 10 vorhandenen Voltage-to-Frequency-Converters (V/F-Converter) 32 zugeführt.

Sein Output ist ein Rechteck-Signal mit einer dem Strom I proportionalen Frequenz f. Die Anzahl der Perioden wird in einem bekannten Vorwärts-Rückwärts-Zähler (Binary-Coded-Decimal-Zähler, BCD-Zähler) oder Binärzähler 33 mit beispielsweise 4 Stellen gezählt. Der Vorwärts-Rückwärts-Zähler 33 weist einen Vorzeicheneingang 43 auf. An diesem Eingang wird, gemäss bekanntem Stand der Technik, dem Zähler die Stromrichtung, ob also Ladung oder Entladung vorliegt, mitgeteilt. Dadurch zählt der Vorwärts-Rückwärts-Zähler 33 während der Ladephase aufwärts und während der Entladephase abwärts. Der Ausgang des Vorwärts-Rückwärts-Zählers 33 ist mit dem Eingang eines Multiplexers, beispielsweise eines Bus-Transceivers 34, verbunden. Nach beispielsweise 10'000 Perioden wird ein Uebertragssignal aktiv, welches an den Bus-Transceiver 34 übergeben wird, der dieses Bit über die Datenleitung 31 an einen weiteren Bus-Transceiver 35 in der Anzeigeeinheit 28, 29 übergibt. Der Ausgang dieses Bus-Transceivers 35 ist mit den Eingängen eines weiteren Vorwärts-Rückwärts-Zählers 36 verbunden. Ein weiters Datenbit, welches seriell über die gleiche Datenleitung 31 übertragen wird, legt auch bei diesem Vorwärts-Rückwärts-Zähler 36 über seinen Vorzeicheneingang 45 fest, ob der Vorwärts-Rückwärts-Zähler 36 aufwärts oder abwärts zählt. Die Werte der 10er, 100er- und 1000er-Stelle werden einem 7-Segment-Decoder 37 zugeleitet, der sie, beispielsweise auf einer 3-stelligen LCD-Anzeige 38, sichtbar macht. Selbstverständlich kann auch jede andere Codierung oder Anzeige-Technologie verwendet werden. Mit Hilfe eines in der Nähe der Anzeige vorhandenen Reset-Schalters 39 kann manuell, beispielsweise über einen Druckschalter, ein Reset-Signal 44 eingegeben werden. Dies ermöglicht es dem Benützer, nach Bedarf jederzeit eine neue Integrationsphase zu starten.

Die Amperestundenzahl, welche auf diese Weise berechnet und angezeigt wird, ist ein wichtiges Mass für den Ladezustand der Batterie, vergleichbar etwa der Anzeige eines Benzinstandsanzeigers bei einem benzinbetriebenen Personenkraftwagen.

Es wäre ein wesentlich höherer Installationsaufwand nötig, wenn für jeden einzelnen Wert einer Vielzahl von physikalischen Grössen eine eigene Datenleitung 13 zu einer oder mehr als einer separaten Anzeigeinheit 28, 29 geführt werden müsste. Die erfindungsgemässe Vereinfachung besteht sowohl darin, Sensoren 14, 21, 40 und eine Verarbeitungseinheit 16 in der Batteriemessklemme 1 selber zu konzentrieren, als auch darin, die gemessenen Werte über eine einzige, zweiadrige Datenleitung 13 seriell zu übermitteln. Die Datenleitung kann dabei auch einadrig sein, wenn ein Masse-Anschluss überall verfügbar ist, wie dies beispielsweise bei einer AutomobilKarosserie der Fall ist. Die serielle Uebermittlung bedingt ein geeignetes und miniaturisiertes Multiplexer- und BusSystem mit Bus-Transceivern 34 und 35. Solche Systeme gehören, in verschiedensten Varianten, zum bekannten Stand der Technik, beispielsweise nach CH 1997 2671/97.

In Fig. 5 ist ein erfindungsgemässes elektrisches Gleichspannungssystem in schematischer Weise dargestellt. Dabei könnte es sich beispielsweise um das elektrische Gleichspannungssystem eines Luft-, Land- oder Wasser-Fahrzeugs handeln. Der positive Anschluss-Pol 9 einer Batterie 42 ist über die Befestigungsmanschette 2 mit der Batteriemessklemme 1 verbunden. Die Batteriemessklemme 1 ist über das Batteriekabel 12 auch mit dem negativen Anschluss-Pol der Batterie verbunden. Das Batteriekabel 11 führt aus dem Gehäuse 10 der Batteriemessklemme 1 heraus und ist, allenfalls unterbrochen durch nicht eingezeichnete Schalter, mit dem Widerstand 26 verbunden, welcher den gesamten Widerstand aller eingeschalteten Energieverbraucher repräsentiert. Aus dem Gehäuse 10 führt weiter die Datenleitung 13, welche mit einer oder mehr als einer Anzeigeeinheit 28, 29 verbunden ist. Eine Energiequelle 30, beispielsweise ein Ladegerät, ein Alternator, ein Solarpanel, ein Windgenerator oder dergleichen ist ebenfalls mit beiden Batteriekabeln 11, 12 verbunden. Die Energiequelle 30 ist durch eine weitere Datenleitung 31 mit der Datenleitung 13 verbunden. Sie enthält weiter nicht eingezeichnete Mittel zur Verarbeitung der Batteriedaten und zur entsprechenden Steuerung des Ladestroms. Das Gehäuse 10 der Batteriemessklemme 1 enthält mindestens einen Sensor 14, 21, 40, beispielsweise für den Strom I, für die Klemmenspannung U oder für die Temperatur. Die Signalverarbeitungseinheit 16 enthält einen Multiplexer, beispielsweise einen Bus-Transceiver 34, sowie typischerweise zusätzlich einen Integrator sowie einen Multiplikator. Der Bus-Transceiver 34 enthält eine Vielzahl von Eingängen und ermöglicht es, über eine einzige zweidrahtige Datenleitung 13 respektive 31 eine Vielzahl verschiedener Daten seriell hintereinander gezielt an definierte Destinationen, beispielsweise an Anzeigeelemente 28, 29, und über die Datenleitung 31 auch an die Energiequelle 30, weiterzuleiten. Mit Hilfe dieser an die Energiequelle 30 weitergeleiteten Daten kann der Ladestrom, angepasst an die Zustandsdaten der Batterie, gezielt optimiert werden, wodurch die Gesamtlebensdauer der Batterie wesentlich vergrössert werden kann.

In einer Variante steht das gesamte System über die Datenleitung 13 mit einem übergeordneten Rechner 48 in Verbindung, der verschiedenste weitere Aufgaben erfüllt. Vom Gleichspannungssystem werden einerseits Daten an den Rechner 48 übermittelt, welcher diese beispielsweise erfasst, protokolliert und archiviert. Andererseits werden vom Rechner 48 Steuerdaten an das Gleichspannungssystem übermittelt, mit welchen beispielsweise Fernsteuerungsaufgaben erfüllt, Sollwerte vorgegeben, neue Integrationsphasen des Amperestunden-Zählers gestartet oder eine Kommunikation mit anderen externen Systemen oder Netzwerken durchgeführt wird. Die Verbindung kann dabei für eine einseitige Uebermittlung, das heisst eine Uebermittlung nur in der einen oder nur in der anderen Richtung, oder aber für eine wechselseitige Uebermittlung in beiden Richtungen ausgelegt sein.

## Patentansprüche

1. Elektrisches Gleichspannungssystem mit einer typischerweise wiederaufladbaren Batterie (42) mit zwei Anschlusspolen (9, 47) verschiedener Polarität, zwei von ihr weg zu einem oder mehreren Verbrauchern führenden Batteriekabeln (11, 12), zwei Anschlussklemmen mit Befestigungsmanschetten (2) aus Metall, mit welchen diese in festem mechanischen, thermischen und elektrischen Kontakt mit je einem der Anschluss-Pole (9, 47) der Batterie (42) stehen, wobei die wegführenden Batteriekabel (11, 12) mit der jeweiligen Befestigungsmanschette (2) fest und thermisch und elektrisch leitend verbunden sind, **dadurch gekennzeichnet, dass**
- mindestens die mit dem einen Anschluss-Pol (9) der Batterie (42) verbundene Anschlussklemme als Batteriemessklemme (1) ausgestaltet ist,
- diese Batteriemessklemme (1) an dem einen Anschluss-Pol (9) durch ein isoliert ins Innere der Batteriemessklemme (1) hineinführendes Batteriekabel (12) mit dem anderen Pol (47) der Batterie (42) elektrisch verbunden ist,
- diese Batteriemessklemme (1) in ihrem. Innern mindestens zwei Sensoren (14, 21, 40) mite einem Ausgang enthält, an welchem der jeweilige Sensor (14, 21, 40) ein elektrisches Signal abgibt, wobei mit jedem diese Sensoren (14, 21, 40) die Spannung, der Strom oder die Temperatur gemessen werden können.
- diese Batteriemessklemme (1) in ihrem Innern eine Signalverarbeitungseinheit (16) enthält,
- die Energieversorgung der integrierten Sensoren (14, 21,40) und der Signalverarbeitungseinheit (16) über die in die Batteriemessklemme (1) hineinführenden Batteriekabel (11, 12) sichergestellt ist,
- die Signalverarbeitungseinheit (16) für jeden der vorhandenen Sensoren (14, 21, 40) einen elektrischen Eingang aufweist, der mit dem Ausgang des betreffenden Sensors (14, 21, 40) elektrisch verbunden ist,
- die Signalverarbeitungsmittel (16) einen elektrischen Ausgang enthalten,
- eine einzige Datenleitung (13) vorhanden ist, welche mit dem Ausgang der Signalverarbeitungsmittel (16) elektrisch verbunden ist und aus dem Innern der Batteriemessklemme (1) hinausführt,
- die Signalverarbeitungseinheit (16) Verarbeitungsmittel enthält, mit welchen aus der Gesamtheit der an sie übergebenen Signale aller vorhandenen Sensoren (14, 21, 40) der Wert von mindestens einer die Batterie betreffenden physikalischen Grösse bestimmt werden kann,
- die Signalverarbeitungseinheit (16) Mittel enthält, mit welchen jede der so bestimmten physikalischen Grössen in eine geeignete Form umgewandelt und der Datenleitung (13) zur Weiterleitung übergeben werden kann.

2. Elektrisches Gleichspannungssystem nach Patentanspruch 1, **dadurch gekennzeichnet, dass**
- unter den Sensoren (14, 21, 40) ein Stromsensor (21) vorhanden ist,
- zwischen der Befestigungsmanschette (2) und dem wegführenden Batteriekabel (11) ein niederohmiger Shunt-Widerstand (25) vorhanden ist,
- der vorhandene Stromsensor (21) ein Signal abgibt, das im Wesentlichen der dem fliessenden Strom (I) proportionalen Spannung über dem Shunt-Widerstand (25) entspricht.

3. Elektrisches Gleichspannungssystem nach Patentanspruch 1, **dadurch gekennzeichnet, dass**
- unter den Sensoren (14, 21, 40) ein Stromsensor (21) vorhanden ist,
- dieser Stromsensor (21) einen in unmittelbarer Nähe des fliessenden Stroms (I) fixierten Widerstand aus Permalloy enthält,
- dieser Stromsensor (21) ein Signal abgibt, das sich aus der Abhängigkeit des elektrischen Widerstands dieses Materials von der Stärke eines Magnetfeldes ergibt, welches hier proportional zum fliessenden Strom (I) ist.

4. Elektrisches Gleichspannungssystem nach Patentanspruch 1, **dadurch gekennzeichnet, dass**
- unter den Sensoren (14, 21, 40) ein Stromsensor (21) vorhanden ist,
- dieser Stromsensor (21) eine in unmittelbarer Nähe des fliessenden Stroms (I) fixierte Hall-Sonde enthält,
- diese Hall-Sonde eine Hall-Spannung erzeugt, welche im Wesentlichen der Stärke eines Magnetfeldes proportional ist, welches proportional zum fliessenden Strom (I) ist,
- eine Kompensationsschaltung zur Erzeugung einer Kompensationsspannung vorhanden ist, mit welcher diese Hall-Spannung auf Null kompensiert werden kann,
- dieser Stromsensor (21) ein Signal abgibt, welches dieser Kompensationsspannung entspricht.

5. Elektrisches Gleichspannungssystem nach Patentanspruch 1, **dadurch gekennzeichnet, dass**
- die Batteriemessklemme (1) in ihrem Innern mindestens einen Sensor für die Klemmenspannung (U) und mindestens einen Sensor für den fliessenden Strom (I) enthält,
- die Signalverarbeitungseinheit (16) Mittel zur Multiplikation zweier physikalischer Grössen enthält,
- mit diesen Mitteln der Signalverarbeitungseinheit (16) das Produkt von Klemmenspannung (U) und Strom (I) berechnet werden kann,
- dieses Produkt durch die Signalverarbeitungseinheit (16) der Datenleitung (13) zur Weiterleitung übergeben werden kann.

6. Elektrisches Gleichspannungssystem nach Patentanspruch 1, **dadurch gekennzeichnet, dass**
- die Batteriemessklemme (1) in ihrem Innern mindestens einen Sensor für den fliessenden Strom (I) enthält,
- die Batteriemessklemme (1) in ihrem Innern einen Zeitmesser enthält,
- die Signalverarbeitungseinheit (16) einen Micro-Prozessor zur Berechnung des Integrals einer physikalischen Grösse über die Zeit enthält,
- der Micro-Prozessor das Integral des Stroms (I) über die Zeit durch die Bildung der Summe aus einer Vielzahl von Produkten aus diskreten Messungen des Stroms (I) zwischen gewissen Zeitintervallen und dem jeweiligen Zeitintervall selbst annähert,
- dieses Integral durch die Signalverarbeitungseinheit (16) der Datenleitung (13) zur Weiterleitung übergeben werden kann.

7. Elektrisches Gleichspannungssystem nach Patentanspruch 1, **dadurch gekennzeichnet, dass**
- die Batteriemessklemme (1) in ihrem Innern mindestens einen Sensor für den fliessenden Strom (I) enthält,
- die Batteriemessklemme (1) in ihrem Innern Mittel zur Integration einer physikalischen Grösse über die Zeit enthält,
- diese Mittel zur Integration einen Voltage-To-Frequency-Converter (32) und einen elektronischen Vorwärts-Rückwärts-Zähler (33) enthalten,
- der Ausgang des Sensors für den Strom (I) mit dem Eingang (46) des Voltage-To-Frequency-Converters (32) verbunden ist,
- der Ausgang des Voltage-To-Frequency-Converters (32) mit dem Eingang des Vorwärts-Rückwärts-Zählers (33) verbunden ist,
- eine dem fliessenden Strom (I) proportionale Frequenz des Voltage-To-Frequency-Converters (32) dem Vorwärts-Rückwärts-Zähler (33) bei der Ladung der Batterie mit positivem, bei der Entladung der Batterie mit negativem Vorzeichen zur Zählung zugeleitet wird,
- der Ausgang des Vorwärts-Rückwärts-Zählers (33) mit einem Eingang der Signalverarbeitungseinheit (16) verbunden ist,
- das so bestimmte Integral des fliessenden Stroms (I) über die Zeit durch die Signalverarbeitungseinheit (16) zur Weiterleitung an eine oder mehr als eine Anzeigeeinheit (28, 29) übergeben werden kann.

8. Elektrisches Gleichspannungssystem nach Patentanspruch 1, **dadurch gekennzeichnet, dass**
- die Ausgabemittel der Signalverarbeitungseinheit (16) einen Bus-Transceiver (34) enthalten,
- der Bus-Transceiver (34) mit der von der Batteriemessklemme (1) wegführenden Datenleitung (13) elektrisch verbunden ist,
- die Datenleitung (13) höchstens zweiadrig ist,
- bei einem oder bei mehreren Empfängern der auf der Datenleitung (13) ankommenden Daten je ein weiterer Bus-Transceiver (35) vorhanden ist.

9. Elektrisches Gleichspannungssystem nach einem der Patentansprüche 1 bis 10, **dadurch gekennzeichnet, dass**
- die Batteriemessklemme (1) in ihrem Innern einen Temperatursensor und einen Stromsensor enthält,
- elektronische Steuermittel vorhanden und mit der elektrischen Energiequelle (30) verbunden sind,
- die elektronischen Steuermittel über eine Datenleitung (31) mit der Datenleitung (13) der Batteriemessklemme (1) verbunden sind,
- in den Steuermitteln Mittel (35) vorhanden sind, mit welchen auf der Datenleitung (31) liegende Daten übernommen werden können,
- in den Steuermitteln Mittel vorhanden sind, um den Ladestrom von der Energiequelle (30) zur Batterie (42), abhängig von der Temperatur der Batterie, bei Ueberschreiten des dieser Temperatur ensprechenden optimalen Werts, auf diesen Wert zu begrenzen.

10. Elektrisches Gleichspannungssystem nach einem der Patentansprüche 1 bis 13, **dadurch gekennzeichnet, dass**
- mindestens eine Anzeigeeinheit (28, 29) zur wahlweisen Anzeige von gemessenen oder berechneten Werten wie Spannung, Strom, Temperatur und Ladungszustand.

11. Elektrisches Gleichspannungssystem nach Patentanspruch 1, **dadurch gekennzeichnet, dass**
- ein übergeordneter Rechner (48) vorhanden ist,
- der Rechner (48) über die Datenleitung (13) mit dem Gleichspannungssystem verbunden ist,
- über die Datenleitung (13) zwischen dem Rechner (48) und dem Gleichspannungssystem in mindestens einer Richtung Daten übermittelt werden können.

## Claims

1. An electrical d.c. voltage system with a typically rechargeable battery (42) with two connection terminals (9, 47) of different polarity, two battery cables (11, 12) leading away from it, two connection terminals with metal fastening collars (2), with which they are in permanent mechanical, thermal and electrical contact with each of the connection terminals (9, 47) of the battery (42), wherein the diverging battery cables (11, 12) are permanently connected to each fastening collar (2) so that they are thermally and electrically conducting, **characterised in that**
- at least the connection terminal connected to a connection terminal (9) of the battery (42) is designed as a battery measuring terminal (1)
- this battery measuring terminal (1) is electrically connected at one connection terminal (9) to the other terminal (47) of the battery (42) by means of a battery cable (12) which, insulated, feeds into the interior of the battery measuring terminal (1),
- this battery measuring terminal (1) includes in its interior at least two sensors (14, 21, 40), each with an output to which each sensor (14, 21, 40) transmits an electrical signal, wherein the voltage, the current or the temperature may be measured with each of these sensors,
- this battery measuring terminal (1) includes in its interior a signal processing unit (16),
- the energy supply to the integrated sensors (14, 21, 40) and the signal processing unit (16) is provided via the battery cables (11, 12,) feeding into the battery measuring terminal (1),
- the signal processing unit (16) has an electrical input for each of the sensors present (14, 21, 40), which input is electrically connected to the output of the sensor concerned (14, 21, 40),
- the signal processing means (16) include an electrical output,
- a single data cable (13) is provided which is electrically connected to the output of the signal processing means(16) and leads out from the interior of the battery measuring terminal (1),
- the signal processing unit (16) includes processing means with which the value of at least one physical quantity relating to the battery can be determined from the totality of the signals from all the sensors present (14, 21, 40) transmitted to it,
- the signal processing unit (16) includes means with which each of the physical quantities thus determined can be converted to a suitable form and transferred to the data cable (13) for further transmission.

2. The electrical d.c. voltage system according to Claim 1, **characterised in that**
- among the sensors (14, 21, 40) a current sensor (21) is provided,
- a low shunt resistance (25) is provided between the fastening collar (2) and the diverging battery cable (11),
- the current sensor present (21) transmits a signal which corresponds essentially to the voltage proportional to the flowing current (I) over the shunt resistance (25).

3. The electrical d.c. voltage system according to Claim 1, **characterised in that**
- among the sensors (41, 21, 40) a current sensor (21) is provided,
- this current sensor (21) includes a fixed Permalloy resistance fixed in the immediate vicinity of the flowing current (I),
- this current sensor (21) transmits a signal which results from the dependence of the electrical resistance of this material on the strength of a magnetic filed, which is here proportional to the flowing current (I).

4. The electrical d.c. voltage system according to Claim 1, **characterised in that**
- among the sensors (41, 21, 40) a current sensor (21) is provided,
- this current sensor (21) includes a Hall sensor fixed in the immediate vicinity of the flowing current (I),
- this Hall sensor generates a Hall voltage which is essentially proportional to the strength of a magnetic field which is proportional to the flowing current (I),
- a compensation circuit is provided for generating a compensation voltage with which this Hall voltage can be compensated to zero,
- this current sensor (21) transmits a signal which corresponds to this compensation voltage.

5. The electrical d.c. system according to Claim 1, **characterised in that**
- the battery measuring terminal (1) includes in its interior at least one sensor for the terminal voltage (U) and at least one sensor for the flowing current (I),
- the signal processing unit (16) includes means for multiplying two physical quantities,
- the product of the terminal voltage (U) and current (I) can be calculated with these means of the signal processing unit (16),
- this product can be transferred by the signal processing unit (16) to the data cable (13) for further transmission.

6. The electrical d.c. voltage system according to Claim 1, **characterised in that**
- the battery measuring terminal (1) includes in its interior at least one sensor for the flowing current (I),
- the battery measuring terminal (1) includes in its interior a time recorder,
- the signal processing unit (16) includes a microprocessor for calculating the integral of a physical quantity over time,
- the microprocessor approximates the integral of the current (I) over time by forming the sum of a plurality of products from discrete measurements of the current (I) between certain time intervals and each time interval itself,
- this integral can be transferred by the signal processing unit (16) to the data cable (13) for further transmission.

7. The electrical d.c. voltage system according to Claim 1, **characterised in that**
- he battery measuring terminal (1) includes in its interior at least one sensor for the flowing current (I),
- the battery measuring terminal (1) includes in its interior means for integrating a physical quantity over time,
- these integrating means include a voltage-to-frequency converter (32) and an electronic up/down counter (33),
- the output of the sensor for the current (I) is connected to the input (46) of the voltage-to-frequency converter (32),
- the output of the voltage-to-frequency converter (32) is connected to the input of the up/down counter (33),
- a frequency of the voltage-to-frequency converter proportional to the flowing current (I) is fed to the up/down counter (33) during charging of the battery with a positive sign, and during discharging of the battery with a negative sign, for counting,
- the output of the up/down counter (33) is connected to an input of the signal processing unit (16),
- the integral of the flowing current (I) thus determined over time can be transferred by the signal processing unit (16) for further transmission to one or more than one display unit (28, 29).

8. The electrical d.c. voltage system according to Claim 1, **characterised in that**
- the output means of the signal processing unit (16) include a bus transceiver (34)
- the bus transceiver (34) is connected to the data cable (13) leading away from the battery measuring terminal (1),
- the data cable (13) has a maximum of two conductors,
- a further bus transceiver (35) is provided for each of one or more receivers of the data arriving on the data cable (13).

9. The electrical d.c. voltage system according to one of Claims 1 to 10, **characterised in that**
- the battery measuring terminal (1) includes in its interior a temperature sensor and a current sensor,
- electronic control means are provided and are connected to the electrical energy source (30),
- the electronic control means are connected by a data cable (31) to the data cable (13) of the battery measuring terminal (1),
- means are provided in the control means for taking over data present on the data cable 31),
- means are provided in the control means for limiting the charging current from the energy source (30) to the battery (42), depending on the temperature of the battery, to the optimum value corresponding to this temperature if it is exceeded.

10. The electrical d.c. voltage system according to one of Claims 1 to 13, **characterised in that**
- at least one display unit (28, 29) is provided for the optional display of measured or calculated values such as voltage, current, temperature and state of charge.

11. The electrical d.c. voltage system according to Claim 1, **characterised in that**
- a general computer (48) is provided,
- the computer (48) is connected by the data cable (13) to the d.c. voltage system,
- data can be transmitted in at least one direction via the data cable (13) between the computer (48) and the d.c. voltage system.

## Revendications

1. Système de tension continue électrique comprenant une batterie (42) rechargeable de façon caractéristique avec deux pôles de raccordement (9, 47) de polarité différente, deux câbles de batterie (11, 12) partant de la batterie et aboutissant à un ou plusieurs consommateurs, deux bornes de raccordement avec manchettes de fixation (2) en métal, avec lesquelles celles-ci sont en contact mécanique, thermique et électrique avec respectivement l'un des pôles de raccordement (9, 47) de la batterie (42), les câbles de batterie (11, 12) partants étant reliés de façon fixe et conductrice thermiquement et électriquement avec la manchette de fixation (2) respective, **caractérisé en ce que**
- au moins la borne de raccordement reliée à un pôle de raccordement (9) de la batterie est conçue comme borne de mesure de batterie (1),
- cette borne de mesure de batterie (1) est reliée électriquement sur un pôle de raccordement (9) par un câble de batterie (12) allant à l'intérieur de la borne de mesure de batterie (1) de façon isolée à l'autre pôle (47) de la batterie (42),
- cette borne de mesure de batterie (1) contient dans son espace intérieur au moins deux capteurs (14, 21, 40) avec respectivement une sortie, sur laquelle le capteur (14, 21, 40) concerné émet un signal électrique, la tension, le courant ou la température pouvant être mesuré avec chacun de ces capteurs (14, 21, 40),
- cette borne de mesure de batterie (1) contient dans son espace intérieur une unité de traitement de signal (16),
- l'alimentation en énergie des capteurs (14, 21, 40) intégrés et de l'unité de traitement de signal (16) est assurée par les câbles de batterie (11, 12) passant à l'intérieur de la borne de mesure de batterie (1),
- l'unité de traitement de signal (16) présente pour chacun des présents capteurs (14, 21, 40) une entrée électrique qui est reliée électriquement à la sortie du capteur (14, 21, 40) concerné,
- les moyens de traitement de signal (16) contiennent une sortie électrique,
- une unique ligne de données (13) est présente, laquelle est reliée électriquement à la sortie des moyens de traitement de signal (16) et sort de l'intérieur de la borne de mesure de batterie (1),
- l'unité de traitement de signal (16) contient des moyens de traitement avec lesquels, à partir de la totalité des signaux qui lui ont été transmis de tous les capteurs (14, 21, 40) présents, on peut déterminer la valeur d'au moins une grandeur physique concernant la batterie,
- l'unité de traitement de signal (16) contient des moyens, avec lesquels chacune des grandeurs physiques ainsi déterminées est transformée dans une forme appropriée et peut être remise à la ligne de données (13) pour la transmission.

2. Système de tension continue électrique selon la revendication 1, **caractérisé en ce que**
- un capteur de courant (21) est présent parmi les capteurs (14, 21, 40),
- une résistance de shuntage (25) de basse impédance est présente entre la manchette de fixation (2) et le câble de batterie (11) partant,
- le présent capteur de courant (21) émet un signal qui correspond sensiblement à la tension proportionnelle au courant circulant (1) sur la résistance de shuntage.

3. Système de tension continue électrique selon la revendication 1, **caractérisé en ce que**
- un capteur de courant (21) est présent parmi les capteurs (14, 21, 40),
- ce capteur de courant (21) contient une résistance en Permalloy fixée à proximité immédiate du courant (I) en circulation,
- ce capteur de courant (21) émet un signal qui est obtenu à partir de la dépendance entre la résistance électrique de ce matériau et l'intensité d'un champ magnétique, lequel est proportionnel ici au courant (I) en circulation.

4. Système de tension continue électrique selon la revendication 1, **caractérisé en ce que**
- un capteur de courant (21) est présent parmi les capteurs (14, 21, 40),
- ce capteur de courant (21) contient une sonde de Hall fixée à proximité immédiate du courant (I) en circulation,
- cette sonde de Hall génère une tension de Hall qui est largement proportionnelle à l'intensité d'un champ magnétique, lequel est proportionnel au courant (I) en circulation,
- un circuit de compensation est présent pour générer une tension de compensation, avec laquelle cette tension de Hall peut être compensée par rapport à zéro,
- ce capteur de courant (21) émet un signal qui correspond à cette tension de compensation.

5. Système de tension continue électrique selon la revendication 1, **caractérisé en ce que**
- la borne de mesure de batterie (1) contient dans son espace intérieur au moins un capteur pour la tension aux bornes (U) et au moins un capteur pour le courant (I) en circulation,
- l'unité de traitement de signal (16) contient des moyens pour la multiplication de grandeurs physiques,
- le produit de la tension aux bornes (U) et de l'intensité (I) peut être calculé avec ces moyens de l'unité de traitement de signal (16),
- ce produit peut être remis par l'unité de traitement de signal (16) à la ligne de données (13) pour l'acheminement.

6. Système de tension continue électrique selon la revendication 1, **caractérisé en ce que**
- la borne dé mesure de batterie (1) contient dans son espace intérieur au moins un capteur pour le courant (I) en circulation,
- la borne de mesure de batterie (1) contient dans son espace intérieur une minuterie,
- l'unité de traitement de signal (16) contient un microprocesseur pour le calcul de l'intégrale d'une grandeur physique en fonction du temps,
- le microprocesseur approche l'intégrale du courant (I) en fonction du temps par la formation de la somme à partir d'une grande quantité de produits résultant de mesures discrètes du courant (I) entre certains intervalles de temps et l'intervalle de temps respectif,
- cette intégrale peut être remise par l'unité de traitement de signal (16) à la ligne de données (13) pour l'acheminement.

7. Système de tension continue électrique selon la revendication 1, **caractérisé en ce que**
- la borne de mesure de batterie (1) contient dans son espace intérieur au moins un capteur pour le courant (I) en circulation,
- la borne de mesure de batterie (1) contient dans son espace intérieur des moyens pour l'intégration d'une grandeur physique en fonction du temps,
- ces moyens contiennent pour l'intégration un convertisseur tension-fréquence (32) et un compteur-décompteur (33) électronique,
- la sortie du capteur pour le courant (I) est reliée à l'entrée (46) du convertisseur (32) tension-fréquence,
- la sortie du convertisseur tension-fréquence (32) est reliée à l'entrée du compteur-décompteur (33),
- une fréquence, proportionnelle au courant (I) en circulation, du convertisseur tension-fréquence (32) est amenée pour le comptage au compteur-décompteur (33) avec un signe positif lors de la charge de la batterie et avec un signe négatif lors de la décharge de la batterie,
- la sortie du compteur-décompteur (33) est reliée à une entrée de l'unité de traitement de signal (16),
- l'intégrale ainsi définie du courant (I) en circulation peut être remise en fonction du temps par l'unité de traitement de signal (16) pour l'acheminement ultérieur à une ou plus d'une unité d'affichage (28, 29).

8. Système de tension continue électrique selon la revendication 1, **caractérisé en ce que**
- les moyens de sortie de l'unité de traitement de signal (16) contiennent un émetteur-récepteur de bus (34),
- l'émetteur-récepteur de bus (34) est relié électriquement à la ligne de données (13) partant de la borne de mesure de batterie (1),
- la ligne de données (13) est au maximum à deux brins,
- dans le cas d'un ou de plusieurs récepteurs des données arrivant sur la ligne de données (13), un autre émetteur-récepteur de bus (35) est présent.

9. Système de tension continue électrique selon l'une quelconque des revendications 1 à 10, **caractérisé en ce que**
- la borne de mesure de batterie (1) contient dans son espace intérieur un capteur de température et un capteur de courant,
- des moyens de commande électroniques sont présents et sont reliés à la source d'énergie (30) électrique,
- les moyens de commande électroniques sont reliés par une unité de données (31) à la ligne de données (13) de la borne de mesure de batterie (1),
- dans les moyens de commande sont présents des moyens (35) qui permettent de prendre en charge des données disposées sur la ligne de données (31),
- dans les moyens de commande sont présents des moyens pour limiter le courant de charge de la source d'énergie (30) à la batterie (42), en fonction de la température de batterie, en cas de dépassement de la valeur optimale correspondant à cette température, à cette valeur.

10. Système de tension continue électrique selon l'une quelconque des revendications 1 à 13, **caractérisé par**
- au moins une unité d'affichage (28, 29) pour l'affichage optionnelle de valeurs mesurées ou de valeurs calculées comme la tension, le courant, la température et l'état de charge.

11. Système de tension continue électrique selon la revendication 1, **caractérisé en ce que**
- un ordinateur (48) prioritaire est présent,
- l'ordinateur (48) est relié par la ligne de données (13) au signal de tension continue,
- des données peuvent être transmises dans au moins une direction sur la ligne de données (13) entre l'ordinateur (48) et le système de tension continue.
